Europäisches Patentamt

European Patent Office

Office européen des brevets

(19)

(11) Numéro de publication: **0 1 16 492**
**B1**

(12) **FASCICULE DE BREVET EUROPEEN**

(45) Date de publication du fascicule du brevet:
05.08.87

(51) Int. Cl.⁴: **H 03 F 1/30,** H 03 G 1/00

(21) Numéro de dépôt: **84400090.1**

(22) Date de dépôt: **17.01.84**

(54) Dispositif de compensation des dérivés du gain en température, d'un amplificateur de signaux électriques hyperfréquences.

(30) Priorité: **21.01.83 FR 8300914**

(43) Date de publication de la demande:
**22.08.84 Bulletin 84/34**

(45) Mention de la délivrance du brevet:
**05.08.87 Bulletin 87/32**

(84) Etats contractants désignés:
**BE DE GB IT NL SE**

(56) Documents cités:
**FR - A - 2 232 139**
**FR - A - 2 251 100**
**GB - A - 1 251 671**
**US - A - 3 387 206**
**US - A - 4 207 538**

(73) Titulaire: **THOMSON-CSF, 173, Boulevard Haussmann,**
**F-75379 Paris Cedex 08 (FR)**

(72) Inventeur: **Blanchandin, Monique, THOMSON-CSF**
**SCPI 173, bld Haussmann, F-75379 Paris Cedex 08 (FR)**
Inventeur: **Girardat, Roland, THOMSON-CSF**
**SCPI 173, bld Haussmann, F-75379 Paris Cedex 08 (FR)**
Inventeur: **Vanestrenvord, Jean Michel, THOMSON CSF**
**SCPI 173, bld Haussmann, F-75379 Paris Cedex 08 (FR)**

(74) Mandataire: **Weinmiller, Jürgen et al,**
**Lennéstrasse 9 Postfach 24, D-8133 Feldafing (DE)**

EP 0 116 492 B1

## Description

L'invention concerne un dispositif de compensation des dérives du gain en température, d'un amplificateur de signaux électriques hyperfréquences.

Il est connu de stabiliser le gain d'un amplificateur au moyen d'une boucle de régulation. Selon ce procédé, une partie de la puissance de sortie de l'amplificateur est prélevée à l'aide d'un coupleur et est appliquée sur l'entrée d'un détecteur, formé généralement par une diode de détection dont la dérive est compensée en température et qui fournit une tension continue sur une première entrée d'un comparateur. Une tension continue de seuil ou de référence est appliquée sur la deuxième entrée du comparateur. La sortie du comparateur fournit un signal d'erreur dont l'amplitude est proportionnelle à l'écart entre la tension détectée et la tension de seuil ou de référence. Le signal d'erreur obtenu agit sur le rapport d'atténuation d'un atténuateur placé dans la chaîne d'amplification, de sorte que le niveau de puissance en sortie de l'amplificateur est maintenu constant quelles que soient les variations de la température.

Un problème se pose cependant, lorsque l'amplificateur transmet simultanément plusieurs fréquences, avec des écarts de fréquence variables, car dans ce cas, la tension en sortie du détecteur ne varie plus seulement en fonction des variations de température mais également en fonction des différentes fréquences transmises, en conséquence de quoi, il n'est plus possible de compenser directement les variations de gain dues à la température par la tension fournie par le détecteur.

Il est également connu de stabiliser le gain d'un amplificateur en intervenant directement sur les valeurs de polarisation des transistors amplificateurs. Ce procédé consiste, par exemple, à compenser la dérive en température d'un transistor à effet de champ en appliquant une tension de correction sur la grille de commande du transistor, ce qui entraine une variation du courant drain et de ce fait une variation de gain. Pour mettre en œuvre ce procédé, il suffit de choisir un élément sensible à la température qui agisse correctement sur la tension de polarisation de la grille du transistor. Cependant ce procédé qui est applicable sur des transistors de bas niveaux, travaillant loin de leurs zones de saturation, est très difficile à mettre en œuvre avec des transistors à effet de champ de puissance. En effet, l'expérience montre que la dérive moyenne d'une chaîne amplificatrice de transistors à effet de champ est à peu près de 0,015 décibels par degré centigrade multipliés par le nombre d'étages constituant l'amplificateur, ce qui conduit par exemple, pour une chaîne d'amplification à huit transistors en cascade soumis à des variations de température à l'intérieur d'une plage par exemple de 100°, à une dérive crête à crête à peu près de 12 décibels. A cause de la grande dynamique de correction exigée, les procédés de compensations par action sur la polarisation des transistors apparaissent de ce fait totalement inefficaces.

Le but de l'invention est de remédier aux inconvénients précités.

Un document US-A 4 207 538 décrit un dispositif de compensation des dérives du gain en température d'un amplificateur de signaux électriques hyperfréquences fournis par une source de signaux hyperfréquences pouvant comporter un transistor à effet de champ bigrille couplé par une première grille à ladite source, et comprenant également un capteur de température couplé à la deuxième grille du transistor bigrille pour commander le gain de ce transistor en fonction des variations de température.

Par contre, l'invention a pour objet un dispositif de compensation des dérives du gain en température d'un amplificateur de signaux électriques hyperfréquences fournis par une source de signaux hyperfréquences, ledit dispositif comprenant un transistor à effet de champ bigrille, couplé par une première grille à la source de signaux hyperfréquence, et un capteur de température couplé à la deuxième grille du transistor bigrille pour commander le gain du transistor bigrille en fonction des variations de température, caractérisé en ce que le capteur de température comprend un amplificateur différentiel, couplé sur une première entrée à des premiers moyens générateurs d'une tension variable en fonction de la température, couplé sur une deuxième entrée à des deuxièmes moyens fournissant une tension fixe de référence et dont la sortie applique une tension de commande sur la deuxième grille du transistor bigrille pour commander le gain du transistor bigrille en fonction de l'écart existant entre la tension variable fournie par les premiers moyens et la tension fixe fournie par les deuxièmes moyens.

D'autres caractéristiques et avantages de l'invention apparaîtront également à l'aide de la description qui va suivre, faite en regard des dessins annexés, donnés uniquement à titre d'exemple et dans lesquels.

La figure 1 représente le schéma synoptique du dispositif de l'invention couplé entre une chaîne d'amplificateurs et une source de signaux hyperfréquences.

La figure 2 est un graphique représentant les variations du gain du transistor bigrille en fonction de la tension de commande appliquée sur sa deuxième grille.

La figure 3 est une représentation du capteur linéaire de température utilisé pour la mise en œuvre du dispositif représenté à la figure 1.

La figure 4 est une courbe représentant les variations du gain du transistor bigrille commandé par le capteur de température.

La figure 5 est un graphique, montrant l'évolution de la puissance de sortie de l'amplificateur en fonction de la fréquence des signaux appliqués par la source de signaux hyperfréquences, au travers du dispositif selon l'invention.

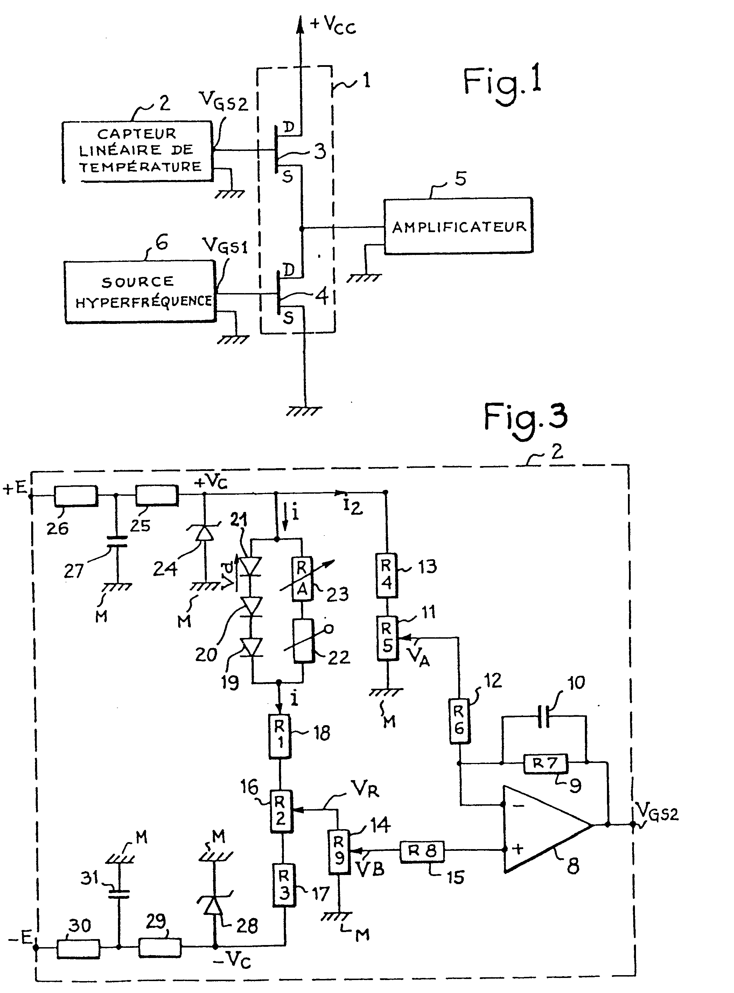

Le dispositif selon l'invention, représenté à la figure 1, comprend un transistor à effet de champ bigrille 1, ainsi qu'un capteur linéaire de température 2. Le transistor bigrille 1 est de type connu et est constitué par deux grilles intercalées entre une électrode de source et une électrode de drain. Un transistor de ce type est notamment commercialisé sous la dénomination NE 46 385 par la Société Japonais «Nippon Electronic Company» connue sous l'abréviation NEC. Pour faciliter la compréhension de son fonctionnement le transistor bigrille 1 est représenté à la figure 1 à l'aide d'un schéma équivalent comportant deux transistors 3 et 4 montés en cascade. La sortie du transistor 1 est constituée par le point de liaison commun entre le drain du transistor 4 et la source du transistor 3. La sortie du transistor 1 est connectée à l'entrée d'un amplificateur hyperfréquence 5. La grille du transistor 4, jouant le rôle de première grille pour le transistor 1, est reliée à la sortie d'une source de signaux hyperfréquences 6. L'électrode de source du transistor 4 est reliée à la masse générale du dispositif. La grille du transistor 3, jouant le rôle de deuxième grille pour le transistor 1, est reliée à la sortie du capteur de température 2. Le drain du transistor 3 est polarisé à une source de tension $+V_{CC}$ par une source d'alimentation extérieure au dispositif non représentée.

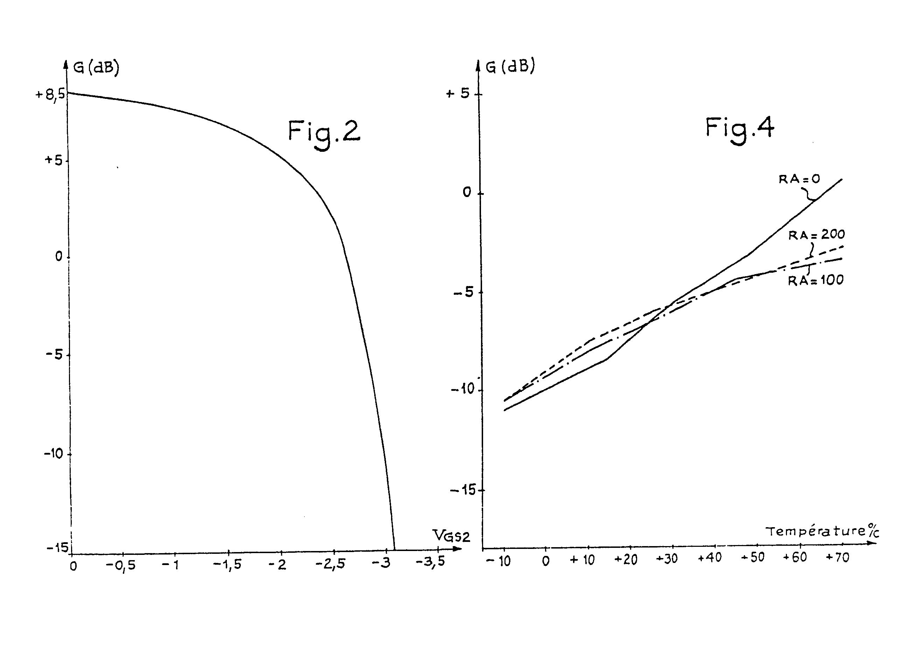

L'évolution du gain du transistor bigrille 1, correspondant au rapport entre le niveau du signal sortant du transistor 1 et le niveau du signal entrant fourni par la source hyperfréquence 6, en fonction de la tension continue de commande de gain appliquée sur la deuxième grille du transistor 1 par le capteur de température 2 est montrée à l'aide du graphique de la figure 2. Sur ce graphique, les courbes représentées correspondent à des mesures du gain d'un transistor NE 46385, polarisé sur la première grille (grille du transistor 4) par une tension continue $V_{GS1}$ de $-2,45$ Volts, alimenté par une tension $V_{CC}$ de $+4$ Volts et un courant de drain $I_{DO}$ de 10 mA. Les valeurs $V_{GS2}$ de la tension continue appliquée sur la deuxième grille du transistor 1 sont indiquées en abscisse, et les valeurs de gain $G = f(V_{GS2})$ correspondantes sont indiquées en ordonnée. Suivant ce graphique, le gain du transistor bigrille varie de $-15$ décibels à environ $+8$ décibels pour une variation de la tension $V_{GS2}$ de 0 à environ $-3$ volts quelles que soient les fréquences des signaux transmis entre 5,85 GHz et 6,425 GHz. Le capteur de température 2, représenté à la figure 3, comprend un amplificateur opérationnel différentiel 8 comprenant une entrée marquée «+» et une entrée marquée «–» et délivrant en sortie le signal de commande $V_{GS2}$ de la grille du transistor à effet de champ 3. La sortie de l'amplificateur opérationnel 8 est rebouclée sur l'entre marquée «–» par l'intermédiaire d'une résistance 9, désignée également par $R_7$, connectée en parallèle avec un condensateur d'intégration 10. L'entrée marquée «–» de l'amplificateur 8 est également reliée au curseur d'un potentiomètre 11 au travers d'une résistance 12, désignée également par $R_6$. Une

extrémité du potentiomètre 11 est reliée à la masse générale M d'alimentation du capteur commune également avec la masse générale M du dispositif et l'autre extrémité est reliée à une alimentation de référence fournissant une tension positive $+V_C$ au travers d'une résistance 13, désignée également par $R_4$. L'entrée marquée «+» de l'amplificateur 8 est reliée à la sortie d'un curseur d'un potentiomètre 14, désigné également par $R_9$, au travers d'une résistance 15, désignée également par $R_8$. Une extrémité du potentiomètre 14 est reliée à la masse générale M d'alimentation du capteur. L'autre extrémité du potentiomètre 14 est reliée au curseur d'un potentiomètre 16, désigné également par $R_2$, dont une extrémité est reliée à une source de tension de référence $-V_C$ au travers d'une résistance 17, désignée également par $R_3$, est dont l'autre extrémité est reliée à la source d'alimentation délivrant la tension de référence $+V_C$ au travers, d'une résistance 18, désignée également par $R_1$, et de diodes 19, 20, 21 montées en série. Le point commun reliant l'extrémité de la résistance 18 à la cathode de la diode 19 est également relié à la sortie de l'alimentation délivrant la tension de référence $+V_C$ au travers d'un élément 22 variable en fonction de la température telle qu'une thermistance ou tout autre moyen équivalent et d'une résistance variable 23, désignée également par RA, montées en série. La source d'alimentation délivrant la tension de référence $+V_C$ est constituée par une diode Zener 24 dont l'anode est reliée à la masse générale M d'alimentation du capteur et dont la cathode est alimentée par une tension d'alimentation $+E$ fournie par un générateur d'alimentation extérieur au capteur, non représenté, au travers d'une résistance 25 et d'une résistance 26 connectées toutes les deux en série. Le point commun aux résistances 25 et 26 est relié à la masse générale M d'alimentation du capteur au travers d'un condensateur 27. De façon à peu près identique, la tension de référence $-V_C$ est fournie par une diode Zener 28 dont la cathode est reliée à la masse générale M d'alimentation du capteur et dont l'anode est reliée à une source d'alimentation extérieure au capteur, non représentée, fournissant une tension d'alimentation $-E$ au travers d'une résistance 29 et d'une résistance 30 connectées toutes les deux en série. Le point commun aux résistances 29 et 30 est relié à la masse générale d'alimentation du capteur au moyen d'un condensateur 31.

Le fonctionnement du capteur en température qui vient d'être décrit est le suivant. L'amplificateur différentiel 8 amplifie l'écart entre les tensions $V_A$ et $V_B$ obtenues respectivement sur les curseurs des potentiomètres 11 et 14 et fournit la tension $V_{GS2}$ de commande de la deuxième grille du transistor bigrille 1. La tension $V_{GS2}$ obéit à la relation

$$V_{GS2} = G(V_B - V_A) \qquad (1)$$

$$\text{où} \quad G = \frac{R_7}{R_6} \qquad (2)$$

La tension $V_A$ est ajustée par le potentiomètre 11 à une valeur positive fixe qui est liée à la tension $+V_c$ stabilisée obtenue aux bornes de la diode Zener 24 par la relation

$$V_A = \frac{K_1 R_5}{R_4 + R_5} \, V_c \qquad (3)$$

où $K_1$ est le rapport potentiométrique du potentiomètre 11. La tension $V_B$ par contre est variable en fonction de la température car elle est dérivée de la différence de potentiel $V_R$ existant entre le potentiel du curseur du potentiomètre 16 et la masse M générale d'alimentation du capteur, cette différence de potentiel variant en fonction de la tension qui apparaît aux bornes de chacune des diodes 19 à 21. En effet, à la température ordinaire, 25°C, la tension aux bornes d'une diode est d'environ 0,7 V et cette tension diminue lorsque la température ambiante augmente. La diminution de la tension $V_d$ est d'environ 100 mV lorsque la température atteint environ 85°C. A l'inverse lorsque la température ambiante diminue la tension $V_d$ aux bornes d'une diode augmente. Un calcul simple permet à l'aide des éléments du schéma de la figure 3 de déterminer les variations de la différence de potentiel $V_R$ ou de la tension $V_R$, en fonction des variations de la tension $V_d$ aux bornes de chacune des diodes. A une température ambiante quelconque, si i désigne le courant circulant dans la résistance $R_1$ il est possible d'écrire la relation

$$2V_c = 3V_d + (R_1 + R_2 + R_3)i \qquad (4)$$

$$et \quad i = \frac{2V_c - 3V_d}{R_1 + R_2 + R_3} \qquad (5)$$

en supposant dans cet exemple, que le courant $i_2$ circulant dans les résistances $R_4$ et $R_5$ et le courant $i_3$ circulant dans la résistance $R_9$ sont négligeables devant le courant i.

La relation (5) permet encore d'écrire la relation

$$V_R = V_c - 3V_d - (R_1 + kR_2) \, \frac{2V_c - 3V_d}{R_1 + R_2 + R_3} \qquad (6)$$

Si, par rapport à une température ambiante quelconque, la température mesurée par les diodes 19 à 21, diminue, la tension aux bornes de chacune des diodes augmente de $+\Delta V_d$ et l'équation (6) devient

$$V_R + \Delta V_R = V_c - 3(V_d + \Delta V_d) - (R_1 + kR_2) \left[ \frac{2V_c - 3(V_d + \Delta V_d)}{R_1 + R_2 + R_3} \right] \qquad (7)$$

ce qui donne

$$\Delta V_R = -3\Delta V_d \left( \frac{R_2(1-K) + R_3}{R_1 + R_2 + R_3} \right) \qquad (8)$$

Comme $K < 1$, $1 - K$ est positif.

Par conséquent, la tension $V_R$ devient plus négative, en variant proportionnellement à la tension $V_d$ aux bornes d'une diode, lorsque la température diminue.

Le réglage du dispositif représenté à la figure 3 peut être effectué de la manière suivante.

A une température ambiante de référence, par exemple à 25°C, le potentiomètre 16 est ajusté pour fournir une tension $V_R$ nulle et par conséquent pour obtenir une tension $V_B$ nulle sur le curseur du potentiomètre 14. Le potentiomètre 11 est ensuite réglé pour obtenir une tension $V_{GS2}$ en sortie de l'amplificateur 8 d'environ $-2,9$ V ce qui d'après le diagramme de la figure 2 commande l'atténuation du transistor bigrille 1 à une atténuation de $-6$ dB.

Lorsque la température ambiante descend en dessous de 25°C, la tension $V_{GS2}$ qui suit les variations de la tension $V_B$ dans le rapport des résistances 9 et 12 devient plus négative, ce qui entraîne une commande d'atténuation plus grande du transistor bigrille 1 qui vient compenser l'augmentation correspondante en gain de l'amplificateur 5. Cette compensation pourra être très justement équilibrée pour un réglage précis du potentiomètre 14 fournissant la tension $V_B$. Dans le cas contraire, lorsque la température ambiante s'élève au-dessus de 25°C, la tension $V_{GS2}$ devient plus positive, entraînant une atténuation moins grande du transistor bigrille ce qui compense la diminution du gain de l'amplificateur 5. La variation du gain du transistor bigrille commandé par le capteur 2 qui vient d'être décrit est représenté à la figure 4 pour une fréquence de transmission de 6,1 GHz.

Sur la figure 4, on peut constater que l'on obtient une variation de gain à peu près linéaire entre $-10°C$ et $+70°C$, respectivement, de $-11$ dB à environ $+1$ dB lorsque la résistance 23 a une valeur nulle, de $-10,5$ db à environ à $-3$ dB lorsque la résistance 23 a une valeur comprise entre 100 et 200 $\Omega$.

Le résultat obtenu présente une plus grande dynamique lorsque la résistance 23 a une valeur nulle, car dans ce cas, la résistance 23 rend plus efficace le rôle de la thermistance 22. En effet, lorsque la température ambiante est élevée, la résistance de la thermistance diminue et son influence n'est plus négligeable devant celle des trois diodes 19, 20, 21. Cela permet de rendre moins négative la grille du transistor à effet de champ et de compenser la courbure de la caractéristique du gain en fonction de la tension $V_{GS2}$

de commande du transistor bigrille représenté à la figure 2. Ce résultat peut être plus ou moins amélioré en fonction de la valeur de la résistance 23 insérée en série avec la thermistance 22.

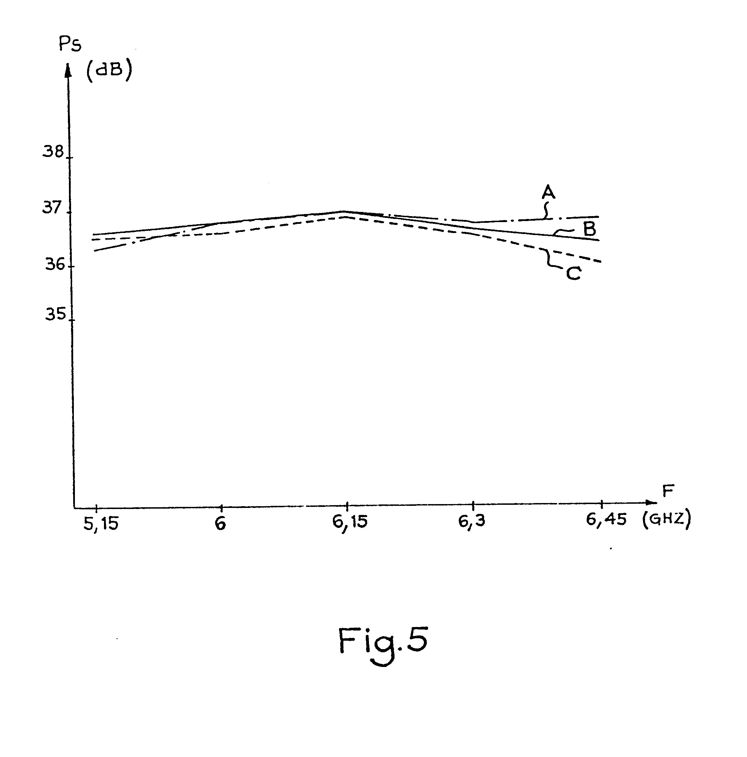

Le graphique représenté à la figure 5 montre des résultats de mesures effectuées sur un amplificateur hyperfréquence compensé en température à l'aide d'un dispositif de l'invention. On peut constater sur la figure que la puissance de sortie fournie par l'amplificateur 5 est maintenue a peu près constante pour des variations de température entre –10°C et +55°C et pour des fréquences de fonctionnement comprises entre 5,15 GHz et 6,45 GHz. La courbe A représente l'évolution du gain en fonction de la fréquence pour une température de –10°C. La courbe B représente l'évolution du gain en fonction de la fréquence pour une température de 25°C et la courbe C représente l'évolution du gain en fonction de la fréquence pour une température de +55°C.

Bien que les principes de la présente invention aient été décrits ci-dessus en relation avec un exemple particulier de réalisation, il faut comprendre que la description n'a été faite qu'à titre d'exemple et ne limite pas la portée de l'invention.

## Revendications

1. Dispositif de compensation des dérives du gain en température d'un amplificateur (5) de signaux électriques hyperfréquences fournis par une source de signaux hyperfréquences (6), ledit dispositif comprenant un transistor à effet de champs bigrille (1) couplé par une première grille à la source de signaux hyperfréquence (6), et un capteur de température (2) couplé à la deuxième grille du transistor bigrille pour commander le gain du transistor en fonction des variations de température, caractérisé en ce que le capteur de température (2) comprend un amplificateur différentiel (8), couplé sur une première entrée à des premiers moyens (19, 20, 21, 22) générateurs d'une tension variable en fonction de la température, couplé sur une deuxième entrée à des deuxièmes moyens (11, 13, 24) fournissant une tension fixe de référence et dont la sortie applique une tension de commande sur la deuxième grille du transistor bigrille pour commander le gain du transistor bigrille en fonction de l'écart existant entre la tension variable fournie par les premiers moyens et la tension fixe fournie par les deuxièmes moyens.

2. Dispositif selon la revendication 1, caractérisé en ce que la variation du gain du transistor bigrille (1) est réalisée linéairement en fonction de la température.

3. Dispositif selon les revendications 1 et 2, caractérisé en ce que le capteur de température (2) agit sur le transistor bigrille (1) de façon à augmenter le gain de ce dernier lorsque la température augmente.

4. Dispositif selon la revendication 1, caractérisé en ce que les premiers moyens comprennent des diodes (19, 20, 21) connectés en série.

5. Dispositif selon la revendication 1, caractérisé en ce que les premiers moyens comprennent des diodes (19, 20, 21) connectées en série et couplées en parallèle à au moins un élément (22) variable en fonction de la température.

6. Dispositif selon l'une quelconque des revendications 1 à 5, caractérisé en ce que les premiers moyens sont couplés à des moyens de réglage (14, 16) de la tension délivrée par les premiers moyens (19, 20, 21, 22) pour obtenir une tension nulle à la sortie des premiers moyens à une température ambiante de référence.

7. Dispositif selon l'une quelconque des revendications 1 à 6, caractérisé en ce que les deuxièmes moyens (11, 13, 24) comprennent des moyens de réglage (11) de la tension de référence pour ajuster le gain du transistor bigrille à une valeur quelconque à la température ambiante de référence.

## Patentansprüche

1. Schaltungsanordnung zur Kompensation der temperaturbedingten Abweichungen des Verstärkungsgrads eines Verstärkers (5) für elektrische Mikrowellensignale, die von einer Mikrowellensignalquelle (6) geliefert werden, mit einem Zweigate-FET (1), der über ein erstes Gate an die Mikrowellensignalquelle (6) angeschlossen ist, und mit einer Temperatursonde (2), die an das zweite Gate des Zweigate-Transistors gekoppelt ist, um den Verstärkungsgrad des Transistors abhängig von den Temperaturveränderungen zu steuern, dadurch gekennzeichnet, dass die Temperatursonde (2) einen Differentialverstärker (8) enthält, der mit einem ersten Eingang an erste Mittel (19, 20, 21, 22) zur Erzeugung einer temperaturabhängigen Spannung, mit einem zweiten Eingang an zweite eine feste Bezugsspannung liefernde Mittel (11, 13, 24) gekoppelt ist und dessen Ausgang eine Steuerspannung an das zweite Gate des Zweigate-Transistors anlegt, um den Verstärkungsgrad des Zweigate-Transistors abhängig von der Spannungsdifferenz zwischen der von den ersten Mitteln gelieferten veränderlichen Spannung und der von den zweiten Mitteln gelieferten Festspannung zu steuern.

2. Anordnung nach Anspruch 1, dadurch gekennzeichnet, dass die Veränderung des Verstärkungsgrads des Zweigate-Transistors (1) in linearer Abhängigkeit von der Temperatur erfolgt.

3. Anordnung nach den Ansprüchen 1 und 2, dadurch gekennzeichnet, dass die Temperatursonde (2) auf den Zweigate-Transistor (1) im Sinne einer Vergrösserung von dessen Verstärkungsgrad einwirkt, wenn die Temperatur ansteigt.

4. Anordnung nach Anspruch 1, dadurch gekennzeichnet, dass die ersten Mittel in Reihe miteinander verbundene Dioden (19, 20, 21) enthalten.

5. Anordnung nach Anspruch 1, dadurch gekennzeichnet, dass die ersten Mittel Dioden (19, 20, 21) enthalten, die in Reihe miteinander verbunden sind und parallel an mindestens ein temperaturabhängiges Element (22) gekoppelt sind.

6. Anordnung nach einem beliebigen der Ansprüche 1 bis 5, dadurch gekennzeichnet, dass die ersten Mittel an Mittel (14, 16) zur Regelung der von den ersten Mitteln (19, 20, 21, 22) gelieferten Spannung gekoppelt sind, um eine Spannung null am Ausgang der ersten Mittel zu erreichen, wenn die Umgebungstemperatur einen Bezugswert besitzt.

7. Anordnung nach einem beliebigen der Ansprüche 1 bis 6, dadurch gekennzeichnet, dass die zweiten Mittel (11, 13, 24) Mittel (11) zur Regelung der Bezugsspannung aufweisen, um den Verstärkungsgrad des Zweigate-Transistors auf einen beliebigen Wert zu regeln, wenn die Umgebungstemperatur auf einem Bezugswert liegt.

## Claims

1. A device for compensating the temperature drift of the gain of an amplifier (5) for ultra-high frequency electric signals supplied by an ultra-high frequency signal source (6), said device comprising a bi-gate-FET (1) coupled by a first gate to the ultra-high frequency signal source (6), and a temperature sensor (2) coupled to the second gate of the bi-gate transistors in order to control the gain of the transistor as a function of the temperature variations, characterized in that the temperature sensor (2) includes a differential amplifier (8) coupled by a first input to first means (19, 20, 21, 22) for generating a variable voltage as a function of temperature, coupled by a second input to second means (11, 13, 24) supplying a fixed reference voltage, the output of said differential amplifier applying a control voltage to the second gate of the bi-gate transistor for controlling the gain of the big-gate transistor as a function of the difference existing between the variable voltage supplied by the first means and the fixed voltage supplied by the second means.

2. A device according to claim, 1, characterized in that the variation of gain of the bi-gate transistor (1) is performed linearily as a function of temperature.

3. A device according to claims 1 and 2, characterized in that the temperature sensor (2) acts on the bi-gate transistor (1) so as to increase the gain of the latter when the temperature increases.

4. A device according to claim 1, characterized in that the first means comprise series connected diodes (19, 20, 21).

5. A device according to claim 1, characterized in that the first means comprise series connected diodes (19, 20, 21) coupled in parallel to at least one variable element (22) as a function of temperature.

6. A device according to any one of claims 1 to 5, characterized in that the first means are coupled to means (14, 16) for adjusting the voltage supplied by the first means (19, 20, 21, 22) for obtaining a zero voltage at the output of the first means at a reference ambiente temperature.

7. A device according to any one of claims 1 to 6, characterized in that the second means (11, 13, 24) comprise means (11) for regulating the reference voltage for adjusting the gain of the bi-gate transistor to any value at the reference ambient temperature.

0 116 492

Fig.1

Fig.3

7

Fig.4

Fig.2

Fig.5